Europäisches Patentamt

European Patent Office

Office européen des brevets

(19)

(11) **EP 0 755 117 A1**

(12) **EUROPÄISCHE PATENTANMELDUNG**

(43) Veröffentlichungstag:
22.01.1997 Patentblatt 1997/04

(51) Int. Cl.⁶: **H03K 17/082**

(21) Anmeldenummer: 96110636.6

(22) Anmeldetag: 02.07.1996

(84) Benannte Vertragsstaaten:
**DE FR GB IT SE**

(30) Priorität: **20.07.1995 DE 19526493**

(71) Anmelder: **TEMIC TELEFUNKEN microelectronic GmbH**
**74072 Heilbronn (DE)**

(72) Erfinder: **Günther, Joachim**
**85051 Ingolstadt (DE)**

(74) Vertreter: **Maute, Hans-Jürgen, Dipl.-Ing.**
**TEMIC TELEFUNKEN microelectronic GmbH**
**Postfach 35 35**
**74025 Heilbronn (DE)**

(54) **Verfahren zur Steuerung eines Laststromkreises**

(57) Verfahren zur Steuerung eines Laststromkreises mit einem Lastelement und einem steuerbaren Schalter, bei dem ein Steuersignal die Zustände „High", „Low" oder „Hochohmig" annehmen kann, mit Hilfe dessen der Schalter gesteuert wird, eine Rückkopplung vom Spannungsabfall über dem Lastelement auf den Eingang vorgesehen ist, welche eine Aufrechterhaltung des „Ein"-Zustandes des Schalters ermöglicht und bei Kurzschluß des Lastelements zur automatischen Abschaltung führt, und darüber hinaus die Zustände „Normalbetriebs-Ein", „Normalbetriebs-Aus" und „Kurzschluß-Aus" detektiert werden können und im „Aus"-Zustand festgestellt werden kann, ob das Lastelement am Laststromkreis angeschlossen oder letzterer unterbrochen ist.

FIG.3

**Beschreibung**

Die Erfindung beschreibt ein Verfahren zur Steuerung eines mit einem Lastelement und einem steuerbaren Schalter aufgebauten Laststromkreises gemäß Oberbegriff des Patentanspruchs 1.

Steuerungen von Laststromkreisen sind bekannt, wobei Kurzschlußsicherungen beispielsweise durch externe Schutzeinrichtungen realisiert wurden. Diese beruhen auf einer Erkennung des sprunghaft ansteigenden Kurzschlußstroms und trennen daraufbin den Laststromkreis. Bei zyklischer Ansteuerung, wie in allen digital gesteuerten Anlagen üblich, kann dabei der Laststromkreis erst beim nächsten Takt-Zyklus abgeschaltet werden. Dadurch wurde der Laststromkreis extrem belastet und es bestand die Gefahr des Durchbrennens oder des beschleunigten Alterns des Laststromkreises, insbesondere von Schalter, Lastelement und Versorgungsspannungsquelle.

Weiterhin sind Steuerungen auf Basis der Zustände „High", „Low" oder „Hochohmig", z.B. als Tristate-Transistor in Tietze/Schenk „Halbleiter-Schaltungstechnik" 10. Auflage Springer Verlag 1993 S. 209, bekannt.

Aufgabe der Erfindung ist es daher, ein Verfahren zur Steuerung eines Laststromkreises zu zeigen, das eine automatische, gegebenenfalls taktzyklenunabhängige Kurzschlußsicherung auf einfache Weise realisiert, sowie eine Schaltungsanordnung zur Durchführung des Verfahrens.

Diese Aufgabe wurde durch die kennzeichnenden Merkmale des Patentanspruchs 1 gelöst, in dem ein Steuersignal die Zustände „High", „Low" oder „Hochohmig" annehmen kann, mit Hilfe dessen ein Schalter gesteuert wird, und ein Rückkopplungsignal vom Spannungsabfall über dem Lastelement erzeugt wird, der bei hochohmigem Zustand des Steuersignals den „Ein"-Zustand des Laststromkreises aufrechterhält. Der Laststromkreis wird durch den „Low"-Zustand des Steuersignals ausgeschaltet oder bei Auftreten eines Lastkurzschlusses aufgrund des Absinkens des Rückkoppelsignals unter den Referenzpegel in den „Aus"-Zustand gesteuert.

Diese Verwendung der grundsätzlich bekannten Zustände erweist sich für dieses Verfahren als vorteilhaft, da es neben den Zuständen „Normalbetriebs-Ein", „Normalbetriebs-Aus" weitere Steuerungsmöglichkeiten eröffnet, insbesondere den „Ein"-Zustandes des Schalters selbständig aufrechterhält und bei Kurzschluß des Lastelements zur automatischen Abschaltung führt. Das Verfahren läßt sich für verschiedenste Anwendungsgebiete einsetzen, indem die Elemente des Laststromkreises, insbesondere der Schalter, sowie die Bildung des Rückkoppelsignals entsprechend angepaßt werden.

Vorteilhafte Weiterbildungen sind in den Patentansprüchen 2 bis 4 gegeben.

So zeigt Patentanspruch 2 eine Weiterbildung des erfindungsgemäßen Verfahrens unter Verwendung eines Knotens, der vom Steuersignal und vom Rückkoppelsignal angesprochen wird, so daß auf einfachste Weise einzig unter Ausnutzung des hochohmigen Zustands die selbständige Aufrechterhaltung des „Ein"- bzw. die sofortige „Aus"-Schaltung bei Kurzschluß gewährleistet wird.

Ein weiteres bevorzugtes Ausführungsbeispiel nach Patentanspruch 3 ermöglicht die Detektierbarkeit der Zustände von Schalter und Lastelement ermöglicht, was für viele Anwendungen von Vorteil ist. So kann nach dem Einschalten des Schalters im hochohmigen Zustand des Steuersignals mittels einer Ausleseeinheit detektiert werden, ob das Lastelement angeschlossen ist oder ein Kurzschluß des Lastelements aufgetreten ist, was zur Abschaltung führte. Dies kann sinnvollerweise zum Beispiel einen erneuten Einschaltversuch unterbinden.

Schließlich ist die Weiterbildung nach Patentanspruch 4 besonders vorteilhaft, die zusätzlich die Detektion der Unterbrechung am Lastelement im „Normalbetriebs-Aus" ermöglicht, was zum Beispiel zum Unterbinden eines Einschaltversuchs im Leerlauf dienen kann.

Zur Durchführung des erfindungsgemäßen Verfahrens dient nach Patentanspruch 5 eine einfache Schaltungsanordnung, die einen Komparator aufweist.

Eine Schaltungsanordnung zur Durchführung des Verfahrens gibt Patentanspruch 6 an, wonach auf einfachste Weise eine hochohmige Überbrückung des Schalters vorgesehen ist.

Ferner zeigt Patentanspruch 7 eine vorteilhafte Weiterbildung der Schaltungsanordnung zur Durchführung des erfindungsgemäßen Verfahrens durch Einsatz einer elektronischen Schaltendstufe (T). Diese ermöglicht eine bautechnisch komplexe Realisierung von Schaltungen zur Durchführung des Verfahrens, die einen Großteil der Anwendungen abdecken, wobei durch Verlustleistung und maximale Schaltströme und -spannungen gegebenenfalls andere Schalter notwendig werden.

Weiterhin zeigt Patentanspruch 8 eine schaltungstechnisch einfache Realisierungsmöglichkeit der Rückkopplung, welche aus dem Spannungsabfall über dem Lastelement direkt das Rückkoppelsignal gewinnt und gleichzeitig auch eine Sicherung gegen zu hohe Spannungen beinhaltet. Bei Anwendungen mit extrem hohen Strömen oder Spannungen sind entsprechende Anpassungen denkbar.

Schließlich zeigen die Patentansprüche 9 bis 12 verschiedene Ausführungsmöglichkeiten der Schaltungsanordnung zur Durchführung des Verfahrens, die in vorteilhafter Weise eine Anpassung auf die jeweiligen Anwendungsfälle ermöglichen und alle schaltungstechnisch einfach zu realisieren sind.

Die Erfindung soll nachfolgend anhand von Ausführungsbeispielen bezugnehmend auf die Figuren näher erläutert werden.

Kurze Beschreibung der Figuren:

EP 0 755 117 A1

Figur 1    Diagramm der Funktionsverläufe in den verschiedenen Schaltsituationen,

Figur 2    Blockschaltbild des dem Verfahren zu Grunde liegenden Regelkreises,

Figur 3    Schaltungsanordnung eines ersten Ausführungsbeispiels mit einer elektronischen Schaltendstufe als Schalter,

Figur 4    Schaltungsanordnung eines zweiten Ausführungsbeispiels mit einem Bipolartransistor in Highsideschaltung,

Figur 5    Schaltungsanordnung eines dritten Ausführungsbeispiels mit einem Bipolartransistor in Lowsideschaltung,

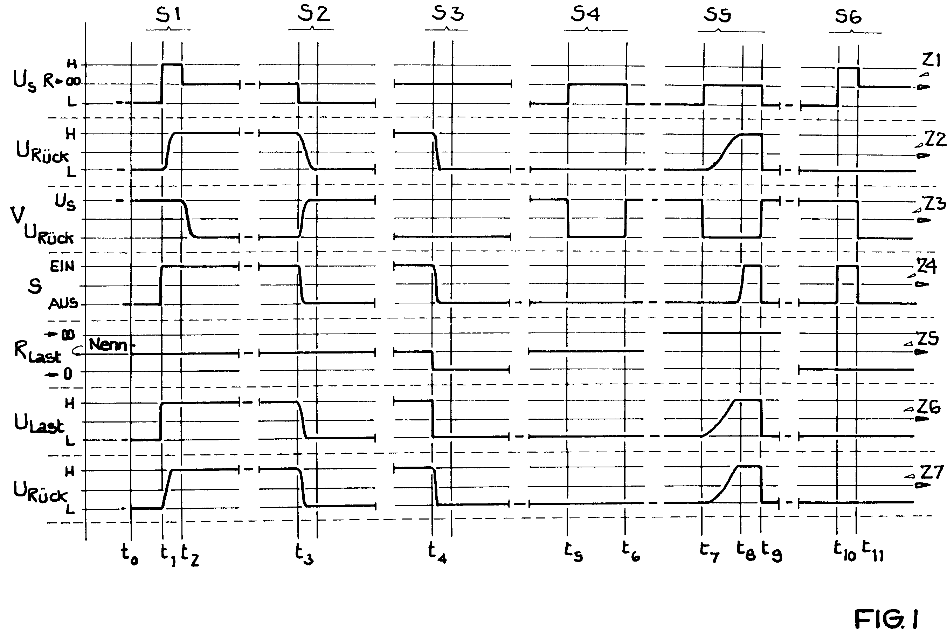

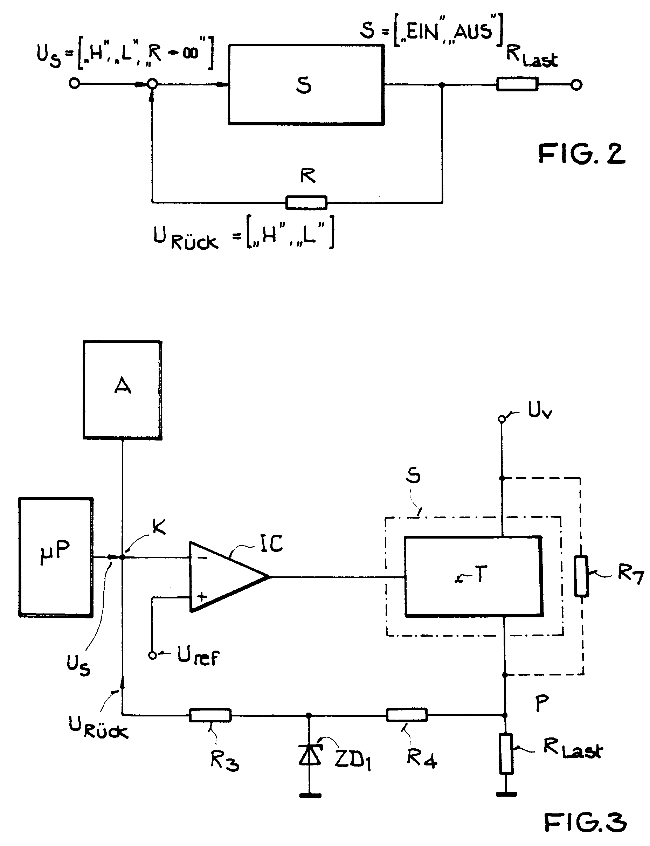

Figur 1 zeigt in den Spalten 1-6 alle möglichen Zustände des Verfahrens bzgl. der in den Zeilen 1-7 dargestellten Pegel bezogen auf die Figur 2. Beobachtet werden in :

1. Zeile    das Steuersignal $U_S$, welches die Zustände „High", „Low" und den hochohmigen Zustand $U_\infty$ annehmen kann

2. Zeile    Rückkoppelsignal $U_{RÜCK}$

3. Zeile    das Vergleichsergebnis V, welches entweder den Wert von $U_S$ oder $U_{RÜCK}$ annehmen kann

4. Zeile    der Schalter S „Ein" oder „Aus"

5. Zeile    Lastelement $R_{LAST}$ im Normalzustand mit Nennlast, mit Kurzschluß (als $R\rightarrow 0$ gekennzeichnet) oder bei abgeklemmter Last im Leerlauf (als $R\rightarrow\infty$ gekennzeichnet)

6. Zeile    der Spannungsabfall $U_{LAST}$ über dem Lastelement $R_{LAST}$

7. Zeile    das Rückkoppelsignal $U_{RÜCK}$ identisch zu Zeile 2.

Die Bezeichnungen beziehen sich dabei auf die Figur 2, welche ein Blockschaltbild des dem Verfahren zu Grunde liegenden Regelkreises zeigt, bestehend aus dem Steuersignal $U_S$, dem Schalter S, der den Laststromkreis $I_{LAST}$ mit dem Lastelement $R_{LAST}$ schließt und der Rückkopplung R mit dem Rückkoppelsignal $U_{RÜCK}$, welches auf das Steuersignal $U_S$ aufgeprägt wird. Nachfolgend werden die einzelnen Zustände des Verfahrens beschrieben :

1. Spalte : „Ein"-Schalten im Normalbetrieb :

Im Normalbetrieb ist das Lastelement $R_{LAST}$ mit Nennlast in den Laststromkreis $I_{LAST}$ geschaltet. Sinnvollerweise wird nur dann „Ein"-geschaltet, wenn zuvor der Schalter S „Aus"-geschaltet war. Zum erstmaligen Inbetriebnehmen empfiehlt sich daher eine Rücksetzung auf „Aus" durch, wie zum Zeitpunkt $t_0$ angedeutet, „Low"-Setzen des Steuersignals $U_S$, wie es als Power-On-Reset üblich ist.

Wird also das Steuersignal $U_S$ auf „Low" gesetzt, schaltet der Schalter S auf „Aus", unabhängig vom Rückkoppelsignal $U_{RÜCK}$, denn gegebenenfalls vorhandene Pegel können durch das „Low"-Setzen des Steuersignals $U_S$ auf Masse abgeleitet werden.

Das „Ein"-Schalten erfolgt nun zum Zeitpunkt $t_1$ durch einen „High"-Impuls des Steuersignals $U_S$ im Mikrosekundenbereich. Dieser liegt deutlich über dem Referenzpegel ($U_{ref}$) und somit wird der Schalter S und damit der Laststromkreis $I_{LAST}$ geschlossen, was zu einem Spannungsabfall $U_{LAST}$ über dem Lastelement $R_{LAST}$ führt, welcher wiederum das Rückkoppelsignal $U_{RÜCK}$ auf „High" steuert. Zum Zeitpunkt $t_2$ schaltet das Steuersignal $U_S$ auf den hochohmigen Zustand $U_\infty$. Damit wird nun der Schalter S sensibel für das Rückkoppelsignal $U_{RÜCK}$ und bleibt aufgrund des „High"-Pegels vom Rückkoppelsignal $U_{RÜCK}$ im „Ein"-Zustand.

2. Spalte : „Aus"-Schalten im Normalbetrieb :

Soll im Normalbetrieb bei hochohmigen Zustand $U_\infty$ des Steuersignals $U_S$ der Schalter S in den „Aus"-Zustand gebracht werden, so wird das Steuersignal $U_S$ auf einen niederohmigen „Low"-Pegel geschaltet. Der Pegel des Rückkoppelsignals $U_{RÜCK}$ kann dabei nicht mehr wirken, da er bedingt durch den höheren Innenwiderstand von $U_{RÜCK}$ überschrieben wird. Es schaltet daher der Schalter S, der Laststromkreis $I_{LAST}$ wird unterbrochen, der Spannungsabfall $U_{LAST}$ wird nahezu Null und damit auch das Rückkoppelsignal $U_{RÜCK}$ auf „Low" gesetzt, so daß der stabile „Aus"-Zustand erreicht ist.

3. Spalte : „Aus"-Schalten bei Kurzschluß des Lastelements :

Tritt im Normalbetrieb bei geschlossenem Laststromkreis $I_{LAST}$ ein Kurzschluß des Lastelements $R_{LAST}$ auf, wie zum Zeitpunkt $t_4$ in Zeile 5, Spalte 3 dargestellt, so fällt der Spannungsabfall $U_{LAST}$ auf nahezu Null. Damit wird auch das Rückkoppelsignal $U_{RÜCK}$ auf „Low" gesetzt und der Schalter S automatisch ausgeschaltet.

3

Detektion der bisherigen Zustände :

In Figur 1 läßt sich gut erkennen, wie die bisherigen Zustände auch leicht mittels einer Ausleseeinheit erkannt werden können. So kann bei hochohmigem Zustand $U_\infty$ des Steuersignals $U_S$ der „Ein"-Zustand des Schalters S durch „High"-Pegel (vgl. Figur 1, Spalte 1, Zeile 2 nach dem Zeitpunkt $t_2$) detektiert werden, der vom Rückkoppelsignal $U_{RÜCK}$ kommt. Bei „Low"-Pegel (vgl. Figur 1, Spalte3, Zeile 2 nach dem Zeitpunkt $t_4$ ) kann auf einen Kurzschluß (vgl. Figur 1, Spalte 3, Zeile 5) des Lastelements $R_{LAST}$ geschlossen werden. Dabei ist eine Detektion sowohl des Rückkoppelsignals $U_{RÜCK}$ als auch des Pegels am Knoten K möglich, wobei bei ersterem zusätzlich noch das Steuersignal $U_S$ beachtet werden muß, was im Knoten K durch Pegelüberlagerung bereits automatisch erfolgt.

4.& 5. Spalte : Detektion der Lastunterbrechung im „Aus"-Zustand

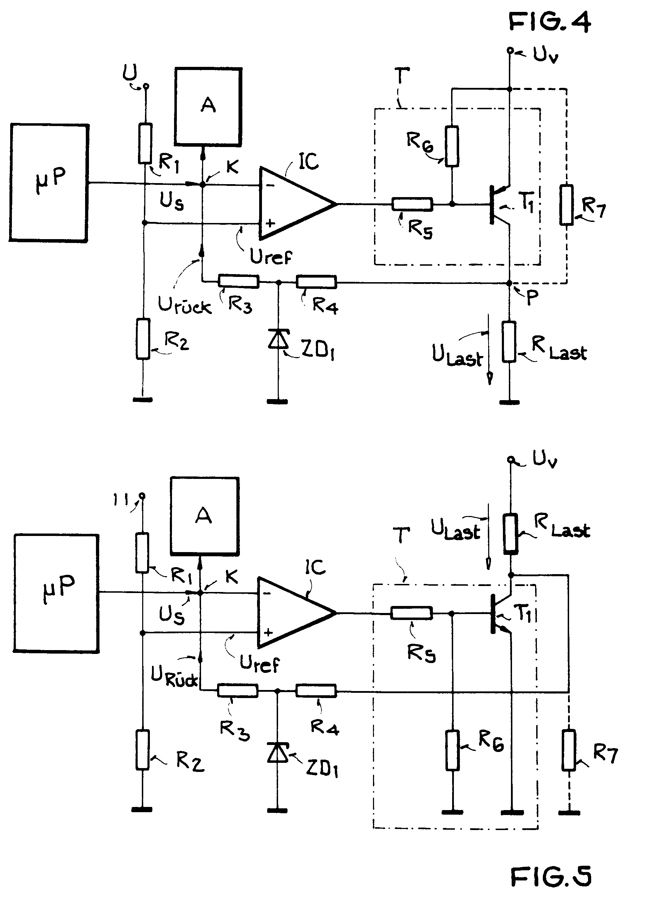

Wird der Schalter S hochohmig überbrückt, wie zum Beispiel mit dem hochohmigen Überbrückwiderstand $R_7$ ($R_7$ >> $R_{LAST}$) in Figur 3, so kann bereits im „Aus"-Zustand des Schalters S geprüft werden, ob das Lastelement $R_{LAST}$ angeschlossen ist. Dazu wird das Steuersignal $U_S$ zum Zeitpunkt $t_5$ bzw. $t_7$ von „Low" auf den hochohmigen Zustand $U_\infty$ geschaltet. Ist nun das Lastelement $R_{LAST}$ angeschlossen, so wird im Laststromkreis $I_{LAST}$ ein Spannungsteiler von

$$U_{LAST} = R_{LAST}/(R_7+R_{LAST}) * U_V < (1/10\ U_V) < U_{REF}$$

auftreten, was zum „Low"-Pegel des Rückkoppelsignals $U_{RÜCK}$ führt. Ist das Lastelement $R_{LAST}$ abgeklemmt, so tritt

$$R_{LAST} \to \infty \text{ auf mit } U_{LAST} = U_V$$

und damit einen „High-Pegel" des Rückkoppelsignals $U_{RÜCK}$ . Dieses kann aufgrund des hochohmigen Zustands $U_\infty$ des Steuersignals $U_S$ den Schalter S zum Zeitpunkt $t_8$ einschalten, bis das Steuersignal $U_S$ zum Zeitpunkt $t_9$ wieder auf „Low" und damit den Schalter S „Aus"-schaltet.

Dieses Verfahren kann somit auf einfache Weise ein „Ein"-Schalten bei abgeklemmter Last unterbinden.

6. Spalte „Ein"-Schalten bei Kurzschluß

Wird bei Kurzschluß des Lastelements $R_{LAST}$ eingeschaltet, also das Steuersignal $U_S$ mit einem „High"-Impuls im Mikrosekundenbereich angesteuert, so fließt zwischen Zeitpunkt $t_{10}$ und Zeitpunkt $t_{11}$ im Laststromkreis $I_{LAST}$ ein Strom, der einzig durch den Innenwiderstand des Schalters S begrenzt ist. Bei der bevorzugten Ausführung des Schalters S als elektronische Schaltendstufe T z.B. auf Transistorbasis wirkt dabei zusätzlich die endliche Stromverstärkung strombegrenzend. Darüber hinaus sind für Anwendungen mit hohen Strömen und Leistungen weitere strombegrenzende Schaltungsanordnungen denkbar. Zum Zeitpunkt $t_{11}$ wird aufgrund des „Low"-Pegels des Rückkoppelsignals $U_{RÜCK}$ der Schalter S auf „Aus" gesetzt.

Es soll nachfolgend bezugnehmend auf Figur 3 ein erstes Ausführungsbeispiel einer Schaltungsanordnung zur Durchführung des Verfahrens erläutert werden. Es ist ein Komparator IC vorgesehen, der am positiven Eingang den Referenzpegel ($U_{ref}$) führt und diesen mit dem Pegel am Knoten K vergleicht, der von dem Steuersignal $U_S$ und Rückkoppelsignal $U_{RÜCK}$ gebildet wird und der am invertierenden Eingang des Komparators IC geschaltet ist. Der Schalter S ist als elektronische Schaltendstufe T ausgeführt. Das Lastelement $R_{LAST}$ kann sowohl eine ohmische, als auch eine gemischte Last mit kapazitiver oder induktiver Komponente sein.

Der Referenzpegel $U_{ref}$ am nichtinvertierenden Eingang bestimmt den Kurzschlußabschaltpunkt (minimale Spannung an $R_{Last}$). Diese Spannung kann, für einen festen Abschaltpunkt aus einer konstanten Spannung abgeleitet werden. Es ist denkbar, den Referenzpegel ($U_{ref}$) z.B. von einer Konstantspannungsquelle bzw. einer solchen Schaltungsanordnung zu speisen oder aus der Versorgungsspannung U zu gewinnen, so daß eine dynamische Kurzschlußschwelle entsteht.

Die Rückkopplung R erfolgt derart, daß vom Schaltungsknoten P der Spannungsabfall $U_{LAST}$ über dem Lastelement $R_{LAST}$ abgegriffen, über einen strombegrenzten Widerstand $R_4$ und einen Entkoppelwiderstand $R_3$ das Rückkoppelsignal $U_{RÜCK}$ gebildet wird, wobei zwischen strombegrenzenden Widerstand $R_4$ und Entkoppelwiderstand $R_3$ eine Zenderdiode $ZD_1$ auf Masse geschaltet ist, welche einen Überspannungsschutz realisiert. $R_4$ und $ZD_1$ sind erforderlich, um den Eingang des Komparators IC bzw. die Ansteuerschaltung µP durch die Lastspannung nicht zu beschädigen. $R_3$ entkoppelt die rückgeführte Spannung vom Eingang des Komparators IC und erlaubt somit ein erneutes Abschalten.

Zur Detektion der Zustände ist eine Ausleseeinheit A vorgesehen, welche in oben beschriebener Weise die Pegel des Knotens K auswerten kann.

Ergänzend dazu ist eine hochohmige Überbrückung des Schalters S (als elektronische Schaltendstufe T) von einem hochohmigen Überbrückwiderstand $R_7$ mit $R_7$ >> $R_{LAST}$ ausgeführt, was die Detektion einer angeschlossenen Last im „Aus"-Zustand des Schalters S in oben beschriebener Weise ermöglicht.

Eine zweite Schaltungsanordnung in Figur 4 zeigt einen Bipolartransistor in Highsideschaltung als elektronische Schaltendstufe T mit entsprechenden Ansteuerwiderständen $R_5$ und $R_6$.

Eine dritte Schaltungsanordnung zeigt in Figur 5 die elektronische Schaltendstufe T in Lowsideschaltung. In schaltungstechnisch bekannter Weise wird dazu das Lastelement $R_{LAST}$ zwischen Betriebsversorgungsspannung $U_V$ und elektronischer Schaltendstufe T geschaltet, die Ansteuerwiderstände $R_5$ und $R_6$ angepaßt und der Überbrückwiderstand $R_7$ analog über den Schalter S, also zwischen Lastelement $R_{LAST}$ und Masse gelegt.

**Patentansprüche**

1.  Verfahren zur Steuerung eines mit einem Lastelement ($R_{LAST}$) und einem steuerbaren Schalter (S) aufgebauten Laststromkreises ($I_{LAST}$) , bei dem ein Steuersignal ($U_S$) mit einem Referenzpegel ($U_{ref}$) verglichen wird und in Abhängigkeit vom Vergleichsergebnis der Laststromkreis ($I_{LAST}$) mittels des Schalters (S) in den „Ein"- oder „Aus"-Zustand geschaltet wird, gekennzeichnet durch folgende Merkmale :

    - a) das Steuersignal ($U_S$) nimmt einen „High"-Zustand ($U_H$) größer dem Referenzpegel ($U_{ref}$) und einen „Low"-Zustand ($U_L$) kleiner dem Referenzpegel ($U_{ref}$) an sowie einen hochohmigen Zustand ($U_\infty$) an,
    - b) aus dem am Lastelement ($R_{LAST}$) auftretenden Spannungsabfall ($U_{LAST}$) wird ein Rückkoppelsignal ($U_{RÜCK}$) erzeugt, welches über oder unter dem Referenzpegel ($U_{ref}$) liegt und mit diesem verglichen und in Abhängigkeit vom Vergleichsergebnis der Schalter (S) gesteuert wird,
    - c) das Steuersignal ($U_S$) setzt durch einen kurzzeitigen „High"-Pegel ($U_H$) den Schalter (S) in den „Ein"-Zustand, wodurch der Laststromkreis ($I_{LAST}$) geschlossen wird,
    - d) das Steuersignal ($U_S$) schaltet daraufhin in den hochohmigen Zustand ($U_\infty$),
    - e) gleichzeitig durch den geschlossenen Laststromkreis ($I_{LAST}$) ein Spannungsabfall ($U_{LAST}$) derart erzeugt wird, daß das Rückkoppelsignal ($U_{RÜCK}$) über dem Referenzpegel ($U_{ref}$) liegt und dadurch der „Ein"-Zustand des Schalters (S) gehalten wird und
    - f) durch Anlegen des „Low"-Pegels des Steuersignals ($U_S$) der Schalter (S) in den „Aus"-Zustand geschaltet wird oder
    - g) durch einen Kurzschluß des Lastelementes ($R_{LAST}$) das Rückkoppelsignal ($U_{RÜCK}$) kleiner als der Referenzpegel ($U_{ref}$) wird und dadurch der Schalter (S) in den „Aus"-Zustand schaltet.

2.  Verfahren nach Patentanspruch 1, dadurch gekennzeichnet, daß eine das Rückkoppelsignal ($U_{RÜCK}$) bildende Rückkopplung (R) vorgesehen ist derart, daß der Spannungsabfall ($U_{LAST}$) an einem Schaltungsknoten (P) zwischen dem Schalter (S) und dem Lastelement ($R_{LAST}$) abgegriffen wird und das Rückkoppelsignal ($U_{RÜCK}$) über einen weiteren Schaltungsknoten (K) auf das Steuersignal ($U_S$) geprägt wird, was im hochohmigen Zustand ($U_\infty$) des Steuersignals ($U_S$) eine Aufrechterhaltung des „Ein"-Zustandes des Schalters (S) bzw. bei Kurzschluß des Lastelements ($R_{LAST}$) eine automatische „Aus"-Schaltung des Schalters (S) ermöglicht.

3.  Verfahren gemäß Patentanspruch 1 oder 2, dadurch gekennzeichnet, daß zur Detektion der Zustände des Schalters (S) und des Lastelements ($R_{LAST}$) im hochohmigen Zustand ($U_\infty$) des Steuersignals ($U_S$) mittels einer Ausleseeinheit (A) am Knoten (K) bei „Ein"-Zustand des Schalters (S) und angeschlossenem Lastelement ($R_{LAST}$) ein „High"-Pegel und bei Kurzschluß des Lastelements ($R_{LAST}$) ein „Low"-Pegel detektiert werden kann.

4.  Verfahren nach Patentanspruch 3, dadurch gekennzeichnet, daß zur Detektion der Zustände des Lastelements ($R_{LAST}$) die Unterbrechung am Lastelement ($R_{LAST}$) durch hochohmige Überbrückung des Schalters (S) durch „High"-Pegel und bei angeschlossenem Lastelement ($R_{LAST}$) dieses durch „Low"-Pegel am Knoten (K) detektiert werden kann, indem kurzzeitig das Steuersignal ($U_S$) vom „Low"-Zustand auf den hochohmigen Zustand ($U_\infty$) geschaltet wird.

5.  Schaltungsanordnung zur Durchführung der Verfahren nach Patentanspruch 1 bis 3, dadurch gekennzeichnet, daß ein Komparator (IC) vorgesehen ist, welcher an einem ersten Eingang den Referenzpegel ($U_{ref}$) und am zweiten Eingang das Steuersignal ($U_S$) und das Rückkoppelsignal ($U_{RÜCK}$) führt.

6.  Schaltungsanordnung zur Durchführung des Verfahrens nach Patentanspruch 4 , dadurch gekennzeichnet, daß ein Komparator (IC) vorgesehen ist, welcher an einem ersten Eingang den Referenzpegel ($U_{ref}$) und am zweiten Eingang das Steuersignal ($U_S$) und das Rückkoppelsignal ($U_{RÜCK}$) führt und daß eine Überbrückung des steuerbaren Schalters (S) mittels eines hochohmigen Überbrückwiderstandes ($R_7$) vorgesehen ist.

7.  Schaltungsanordnung nach Patentanspruch 5 oder 6, dadurch gekennzeichnet, daß der steuerbare Schalter (S) als elektronische Schaltendstufe (T) ausgeführt ist.

8. Schaltungsanordnung nach Patentanspruch 7, dadurch gekennzeichnet, daß die Rückkopplung mit einem strombegrenzenden Widerstand ($R_4$) und einen Entkoppelwiderstand ($R_3$) ausgeführt ist, wobei zwischen strombegrenzendem Widerstand ($R_4$) und Entkoppelwiderstand ($R_3$) eine Zenerdiode ($ZD_1$) auf Masse geschaltet ist, welche einen Überspannungsschutz realisiert.

9. Schaltungsanordnung nach Patentanspruch 7 oder 8, dadurch gekennzeichnet, daß die elektronische Schaltendstufe (T) als Bipolartransistor mit entsprechendem Widerstandsnetzwerk ausgeführt ist.

10. Schaltungsanordnung nach Patentanspruch 7 oder 8, dadurch gekennzeichnet, daß die elektronische Schaltendstufe (T) als Feldeffekttransistor mit entsprechendem Widerstandsnetzwerk ausgeführt ist.

11. Schaltungsanordnung nach einem der Patentansprüche 7 bis 10, dadurch gekennzeichnet, daß die elektronische Schaltendstufe (T) in Highsideschaltung ausgeführt werden kann, in dem die elektronische Schaltendstufe (T) zwischen einer Betriebsspannung (U) und Lastelement ($R_{LAST}$) geschaltet wird.

12. Schaltungsanordnung nach einem der Patentansprüche 7 bis 10, dadurch gekennzeichnet, daß die elektronische Schaltendstufe (T) in Lowsideschaltung ausgeführt werden kann, in dem die elektronische Schaltendstufe (T) zwischen Lastelement ($R_{LAST}$) und Masse geschaltet wird.

FIG.1

$U_S = \left[\text{„}H\text{"}, \text{„}L\text{"}, \text{„}R \to \infty\text{"}\right]$

$S = \left[\text{„EIN"}, \text{„AUS"}\right]$ $R_{Last}$

S

R

$U_{Rück} = \left[\text{„}H\text{"}, \text{„}L\text{"}\right]$

FIG. 2

A

$U_v$

S

$\mu P$

K

IC

$\backsim T$

$R_7$

$U_S$

$U_{ref}$

$U_{Rück}$

P

$R_3$

$ZD_1$

$R_4$

$R_{Last}$

FIG. 3

FIG. 4

FIG. 5

9

Europäisches Patentamt  **EUROPÄISCHER RECHERCHENBERICHT**  Nummer der Anmeldung
EP 96 11 0636

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| A | GB 2 005 935 A (PHILIPS NV) 25.April 1979<br>* Zusammenfassung *<br>--- | 1 | H03K17/082 |
| A | DE 39 06 886 A (ALPS ELECTRIC CO LTD) 14.September 1989<br>* Zusammenfassung *<br>----- | 1 | |

**RECHERCHIERTE SACHGEBIETE (Int.Cl.6)**

H03K

Der vorliegende Recherchenbericht wurde für alle Patentansprüche erstellt

| Recherchenort | Abschlußdatum der Recherche | Prüfer |
|---|---|---|
| DEN HAAG | 30.Oktober 1996 | Salm, R |

**KATEGORIE DER GENANNTEN DOKUMENTE**

X : von besonderer Bedeutung allein betrachtet
Y : von besonderer Bedeutung in Verbindung mit einer
anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
nach dem Anmeldedatum veröffentlicht worden ist
D : in der Anmeldung angeführtes Dokument
L : aus andern Gründen angeführtes Dokument
................................................................
& : Mitglied der gleichen Patentfamilie, übereinstimmendes
Dokument

EPO FORM 1503 03.82 (P04C03)